# EUROPEAN PATENT SPECIFICATION

(11) **EP 2 278 529 B1**
(45) Date of publication and mention of the grant of the patent: **05.09.2012**
(21) Application number: 10168167.4
(22) Date of filing: 01.07.2010
(51) Int. Cl.: G06K 9/00

(54) **Biometric authentication apparatus**
Biometrische Authentifizierungsvorrichtung
Appareil d'authentification biométrique

(30) Priority: 16.07.2009 JP 2009168095
(43) Date of publication of application: 26.01.2011
(73) Proprietor: Sony Corporation, Tokyo 108-0075 (JP)
(72) Inventor: Ichimura, Isao, Minato-Ku, Tokyo (JP); Kai, Shinichi, Minato-Ku, Tokyo (JP); Watanabe, Toshio, Minato-Ku, Tokyo (JP); Kawashima, Yoshinari, Minato-Ku, Tokyo (JP)
(74) Representative: Mills, Julia

(56) References cited:
- US-A1- 2004 252 867
- US-A1- 2008 031 497
- US-A1- 2008 205 711
- US-A1- 2009 016 578
- US-A1- 2009 161 920

## Description

The present invention relates to a biometric authentication apparatus for authenticating a living body on the basis of data obtained by imaging a structure in a biological region such as a vein or fingerprint.

In a related art, an imaging apparatus for imaging a structure in a biometric region is used for a biometric authentication apparatus or the like and various authentication apparatuses for authenticating a living body using image data of, for example, a fingerprint or vein are proposed. Generally, in such a biometric authentication apparatus, since the imaging apparatus itself is thick, to apply the apparatus to thin equipment, a method of disposing the imaging apparatus on the outside of the authentication apparatus or a method of disposing an optical system (imaging lens) and a detection system (imaging device) of the imaging apparatus independently of each other is mainly employed.

In recent years, however, as various apparatuses become thinner or with limitation in manufacturability or design, as a module which may be directly mounted on such an apparatus, biometric authentication apparatuses using a microlens array as the imaging optical system are proposed (for example, Japanese Unexamined Patent Application Publication Nos. 2006-155575 and 2007-74079).

In the case of performing biometric authentication using, for example, a vein pattern, image data is obtained by using the nature such that hemoglobin in the blood absorbs near infrared light. Consequently, as a light source illuminating a biological region, an LED (Light Emitting Diode) or the like emitting near infrared light is used. However, there is a case that not only the near infrared light necessary for authentication but also outside light which is unnecessary for authentication such as fluorescent light, incandescent light, sunlight, and the like is received by the imaging device. An issue occurs such that authentication precision deteriorates due to the influence of the outside light.

To address the issue, as described in Japanese Unexamined Patent Application Publication No. 2007-74079, a wavelength selection filter which blocks visible light and selectively transmits near infrared light is often provided. However, in the case of using such a wavelength selection filter, although the authentication precision is improved, another issue occurs such that thickness of the entire apparatus increases. It becomes difficult to realize further reduction in thickness of the equipment.

It is therefore desirable to provide a biometric authentication apparatus capable of realizing reduction in thickness while maintaining high authentication precision.

US 2008/0031497 discloses an imaging device with a microlens array that has a light shielding layer between the photoreceptor portion and the microlenses with apertures corresponding to the photoreceptors therein. In one embodiment the selective transmission of light in the measurement wavelength is achieved using a filter separate to the microlens array, while in a second embodiment the selective transmission of light is achieved using a resin applied to a surface of the microlens array which absorbs visible light but is transparent to near-infrared light.

US2008/0205711, US 2004/0252867, US 2009/0161920 and US2009/0016578, disclose biometric information acquisition devices which optically detect biometric information.

Various respective aspects and features of the invention are defined in the appended claims. Combinations of features from the dependent claims may be combined with features of the independent claims as appropriate and not merely as explicitly set out in the claims.

A biometric authentication apparatus of an embodiment of the invention includes: a light source emitting light in a wavelength range including a wavelength range for authentication toward a living body; a microlens array condensing light from the living body and selectively transmitting light in the wavelength range for authentication; an imaging device obtaining image data of the living body on the basis of the light condensed by the microlens array; and an authentication unit authenticating the living body on the basis of the image data obtained by the imaging device.

In the biometric authentication apparatus of an embodiment of the invention, when a living body is illuminated by the light source, the microlens array selectively transmits light in the wavelength range for authentication, and the transmission light is received by the imaging device. The imaging device obtains image data based on the received light in the wavelength range for authentication, and the authentication unit authenticates the living body on the basis of the image data.

According to the biometric authentication apparatus of an embodiment of the invention, the microlens array which condenses light from the living body selectively transmits light in the wavelength range for authentication. Thus, image data of the living body is obtained on the basis of the light in the wavelength range for authentication. That is, the microlens array has the light condensing function and also the wavelength selective-transmitting function, so that light in the wavelength range which is unnecessary for authentication is eliminated, and image data based on the light in the wavelength range necessary for authentication is obtained. Therefore, it is unnecessary to separately provide a wavelength selective-transmission filter in the apparatus. Thus, reduction in thickness is realized while maintaining high authentication precision.

Other and further objects, features and advantages of embodiments of the invention will appear more fully from the following description.
Embodiments of the invention will now be described with reference to the accompanying drawings, throughout which like parts are referred to by like references, and in which:

FIG. 1 is a functional block diagram of a biometric authentication apparatus according to an embodiment of the present invention.

FIG. 2 is a cross section of the biometric authentication apparatus illustrated in FIG. 1.

FIG. 3 is a characteristic diagram illustrating transparent wavelength of a microlens array illustrated in FIG. 1.

FIGs. 4A and 4B are plan view and side view of the microlens array illustrated in FIG. 1.

FIGs. 5A and 5B are plan view and side view of a light shield unit illustrated in FIG. 1.

FIGs. 6A and 6B are plan views of an imaging device illustrated in FIG. 1.

FIGs. 7A and 7B are schematic views for explaining a method of assembling the microlens array, the light shield unit, and the imaging device illustrated in FIG. 1.

FIG. 8 is a cross section of a biometric authentication apparatus according to a related art.

FIG. 9 is a schematic diagram for explaining the operation of the biometric authentication apparatus illustrated in FIG. 8.

An embodiment of the present invention will be described in detail below with reference to the drawings in the following order.
(1) General configuration
(2) Assembling method

### (1) General Configuration

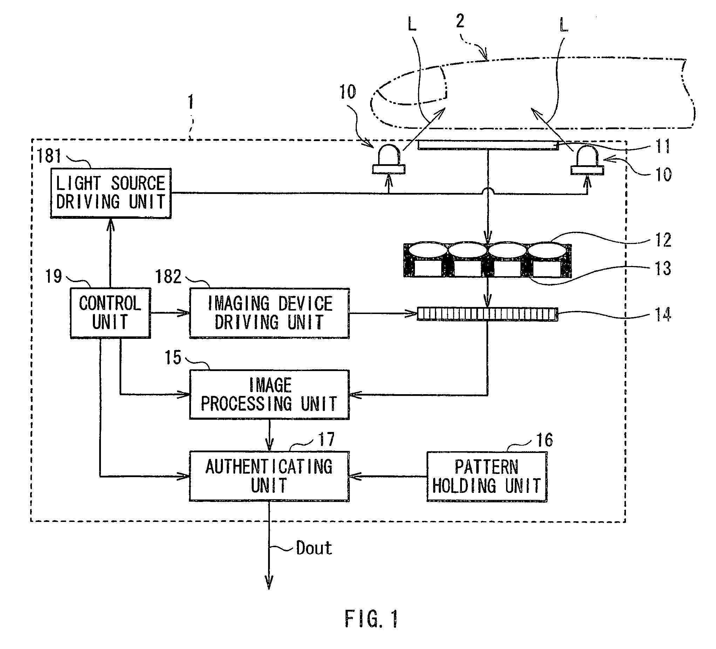

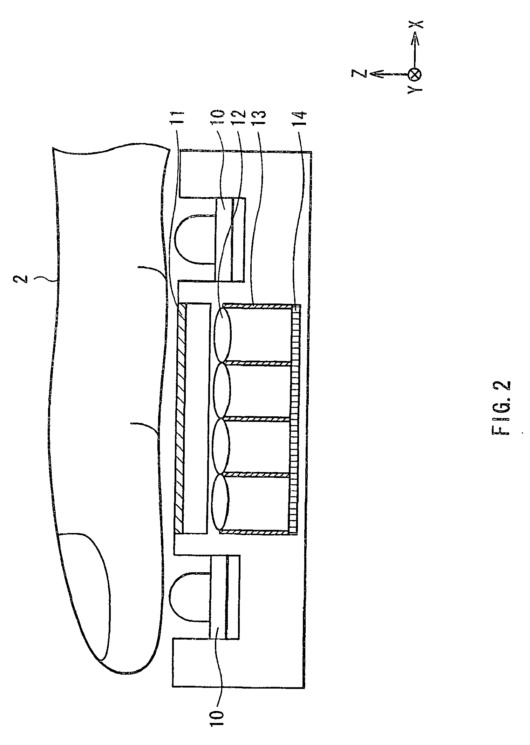

FIG. 1 illustrates a general configuration of a biometric authentication apparatus 1 according to an embodiment of the present invention. FIG. 2 illustrates a Z-X sectional configuration of the biometric authentication apparatus 1. The biometric authentication apparatus 1 captures an image of a structure of, particularly, a living body (for example, a finger tip) 2 such as a vein and performs authentication. The biometric authentication apparatus 1 has a light source 10, a detecting unit 11, a microlens array 12, a light shield unit 13, an imaging device 14, an image processing unit 15, a pattern holding unit 16, an authenticating unit 17, a light source driving unit 181, an imaging device driving unit 182, and a control unit 19.

The light source 10 emits light toward the living body 2 as an object to be imaged and is constructed by, for example, an LED or the like. The light source 10 is provided, for example, on the same side of the imaging device 14 with respect to the living body 2 in the positions of both sides in the longitudinal direction (X direction) of the living body 2. In the case of imaging a structure in the living body 2, for example, a vein, the light source 10 emits light in a wavelength range of near infrared light (a wavelength range of about 700 nm to 1,200 nm).

The detecting unit 11 is, for example, cover glass or the like and is a region (face) for detecting the living body 2, that is, a region (face) on which the living body 2 is put. The living body 2 does not have to be in direct contact with the detecting unit 11 but may be put over the detecting unit 11.

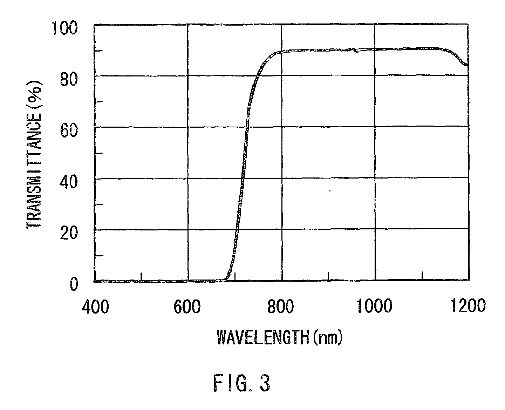

The microlens array 12 is disposed so that, for example, an image of an observation face of the inside of the living body 2 is formed on the light reception face of the imaging device 14 below the detecting unit 11, and collects light emitted to the living body 2. The microlens array 12 is formed by, for example, injection molding with a material obtained by adding a colorant (light shied material) such as pigment or dye to a thermoplastic transparent resin material such as cycloolefin resin, polyolefin resin, or polycarbonate resin as a base material (first resin layer). At this time, by kneading, as a colorant, for example, an organic compound, native mineral, or the like that blocks visible light into the thermoplastic resin (base material), the microlens array 12 is provided with a wavelength selective transmitting function of blocking light in a wavelength range of 700 nm or less as illustrated in FIG. 3. In other words, the microlens array 12 has the function of selectively passing light in the wavelength range of the light source 10 used for authentication (the wavelength range of near infrared light). The colorant is selected in consideration of the optical characteristics such as the transmittance characteristic and the birefractive characteristic in the wavelength range used in the molded microlens array 12.

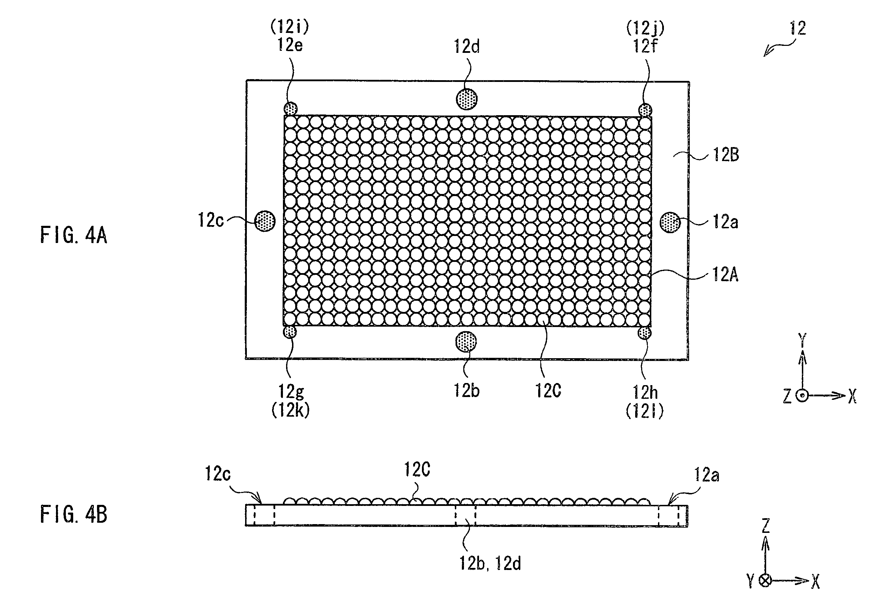

The microlens array 12 molded in such a manner has, as illustrated in FIGs. 4A and 4B, a lens region 12A having a rectangular shape in which a plurality of microlenses 12C are closely arranged in a matrix, and a peripheral region 12B. In the peripheral region 12B openings 12a to 12d are provided in center parts of sides of the rectangular shape in the lens region 12A. In addition, through holes 12e to 12h or microlenses 12i to 12l are formed in positions corresponding to both ends of long sides of the lens region 12A in the peripheral region 12B.

The light shield part in the light shield unit 13 is provided in each boundary region between neighboring microlenses 12C in the microlens array 12. In other words, the light shield unit 13 has openings 13C in correspondence with the plurality of microlenses 12C. The light shield unit 13 blocks light entering into the microlens array 12 or light emitted from the microlens array 12 in selective regions, thereby controlling rays of light entering into the imaging device 14 side. In a manner similar to the microlens array 12, the light shield unit 13 is formed by injection molding with a material obtained by adding a colorant to a material which blocks near infrared light, for example, ABS (acrylonitrile butadiene styrene) as a base material (second resin layer). At this time, by kneading, as a colorant, for example, an optical functional material such as a polymer material or metal material into the thermoplastic resin (base material), the light shield unit 13 is also provided with the function of blocking visible light in addition to the near infrared light. As the colorant, an opaque material having excellent molding characteristic is selected. The base material of the light shield unit 13 is not limited to the above-described ABS but may be, for example, PMMA (acrylic), PPS (polyphenylenesulfide), LCP (liquid crystal polymer), or the like.

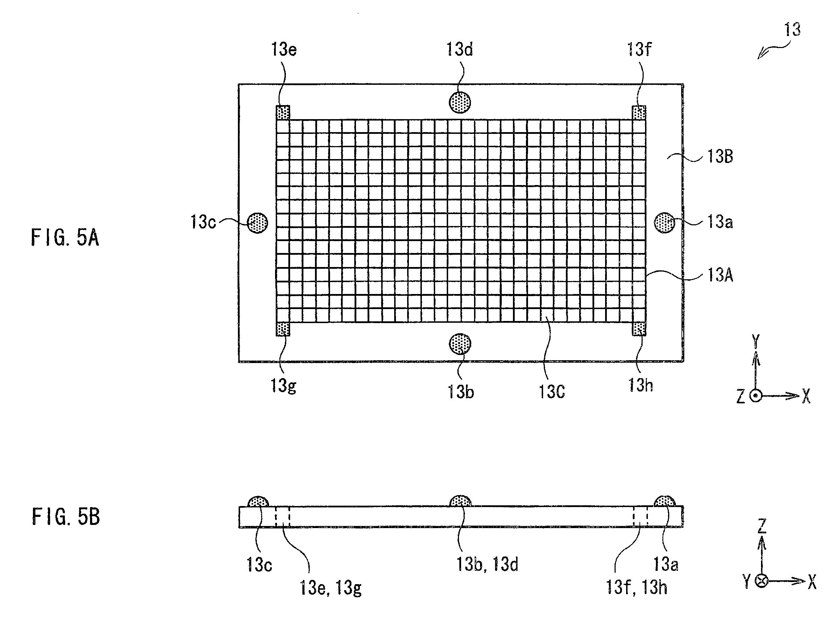

The light shield unit 13 molded in such a manner has, as illustrated in FIGs. 5A and 5B, a light shield region 13A and a peripheral region 13B. In the peripheral region 13B, projections 13a to 13d are provided in positions opposing the openings 12a to 12d, respectively, in the microlens array 12. In addition, through holes 13e to 13h are formed in positions opposing the through holes 12e to 12h or microlenses 12i to 12l, respectively, in the microlens array 12.

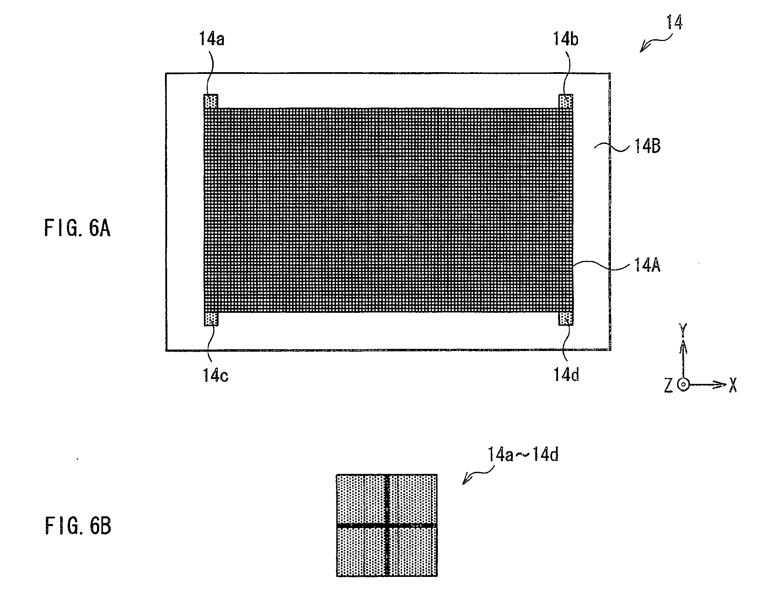

The imaging device 14 is provided to receive light from the microlens array 12 and obtain image data, and is disposed on the focal plane of the microlens array 12. The imaging device 14 is constructed by, for example, a plurality of CCDs (Charge Coupled Devices), CMOS (Complementary Metal Oxide Semiconductors), or the like arranged in a matrix. Like the microlens array 12 and the light shield unit 13, as illustrated in FIG. 6A, the imaging device 14 has an imaging device region 14A and a peripheral region 14B. In the peripheral region 14B, alignment marks 14a to 14d are provided in positions opposing the through holes 12e to 12h (or the microlenses 12i to 12l) and the through holes 13e to 13h, respectively, in the peripheral regions 12B and 13B in the microlens array 12 an the light shield unit 13. FIG. 6B is an enlarged view illustrating an example of the alignment marks 14a to 14d. However, the present invention is not limited to the shape. The alignment marks 14a to 14d of another shape may be also used.

The image processing unit 15 performs predetermined image processing on the image data obtained by the imaging device 14 and outputs the processed data to the authenticating unit 17 in accordance with control from the control unit 19. The image processing unit 15, and the authenticating unit 17 and the control unit 19 which will be described later are constructed by, for example, microcomputers or the like.

The pattern holding unit 16 is a part that holds a living body authentication pattern to be used at the time of biometric authentication (a pattern to be compared with a pattern obtained by imaging at the time of authentication and obtained by imaging a living body in advance). The pattern holding unit 16 is constructed by a nonvolatile recording device (for example, an EEPROM (Electrically Erasable Programmable Read Only Memory) or the like).

The authenticating unit 17 is a part for authenticating the living body 2 by comparing an imaging pattern output from the image processing unit 15 and a living body authentication pattern held in the pattern holding unit 16 in accordance with control from the control unit 19.

The light source driving unit 181 performs light emission drive of the light source 10 in accordance with the control from the control unit 19. The imaging device driving unit 182 performs imaging drive (light reception drive) of the imaging device 14 in accordance with the control from the control unit 19. The control unit 19 controls the operations of the image processing unit 15, the authenticating unit 17, the light source driving unit 181, and the imaging device driving unit 182.

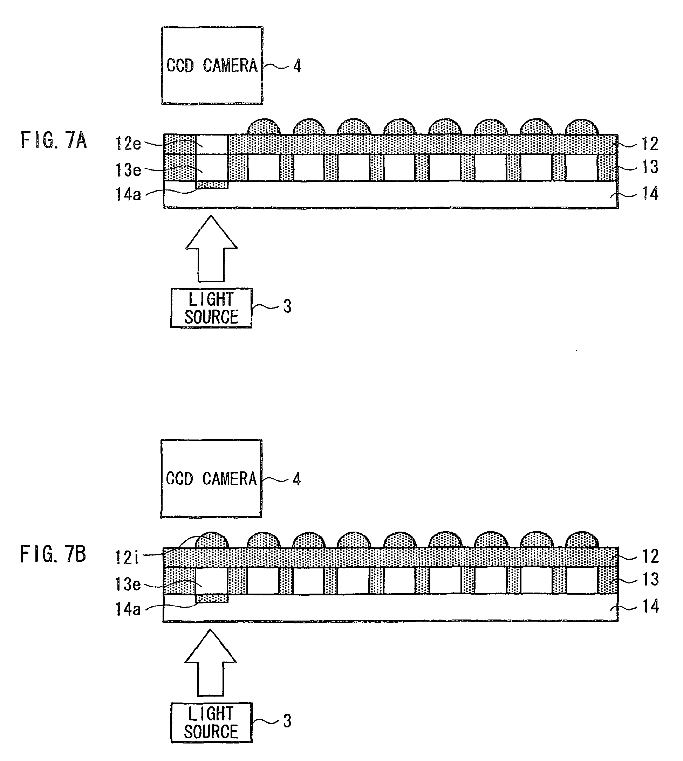

Next, with reference to FIGs. 7A and 7B, a method of assembling the microlens array 12, the light shield unit 13, and the imaging device 14 described above (a layer stacking method) will be explained.

### (2) Assembling Method

In the peripheral region 12B in the microlens array 12, as an alignment mechanism at the time of assembly to be described below, as mentioned above, the openings 12a to 12d, the through holes 12e to 12h, or the microlenses 12i to 12l are formed. Similarly, in the peripheral region 13B in the light shield unit 13, as an alignment mechanism, the projections 13a to 13d and the through holes 13e to 13h are formed. In the peripheral region 14B in the imaging device 14, as an alignment mechanism, the alignment marks 14a to 14d are provided.

First, the microlens array 12 and the light shield unit 13 are assembled. At this time, the projections 13a to 13d in the light shield unit 13 are fit in the openings 12a to 12d in the microlens array 12, respectively. Consequently, the center position of each of the microlenses 12C on the microlens array 12 and that of each of the openings formed in the light shield unit 13 match without adjustment. In such a manner, the microlens array 12 and the light shield unit 13 are integrally provided.

Next, a member obtained by integrating the microlens array 12 and the light shield unit 13 is further assembled with the imaging device 14. As the assembling method, there are the following two methods. As the first method, the case of providing the through holes 12e to 12h in the peripheral region 12B of the microlens array 12 will be described. In this case, as illustrated in FIG. 7A, while emitting light to the lower side of the imaging device 14 by using the light source 3, the alignment marks 14a to 14d are observed by a CCD camera 4 or the like from above the microlens array 12. The member obtained by integrating the microlens array 12 and the light shield unit 13 is moved by not-illustrated moving means, positioned, and aligned. On the other hand, as the second method, the case of providing the microlenses 12i to 12l in the peripheral region 12B of the microlens array 12 will be described. In this case, as illustrated in FIG. 7B, in a manner similar to the first method, while emitting light to the lower side of the imaging device 14, the alignment marks 14a to 14d are observed over the microlenses 12i to 12l by the CCD camera 4 or the like from above the microlens array 12. In a manner similar to the first method, the member obtained by integrating the microlens array 12 and the light shield unit 13 is moved by not-illustrated moving means, positioned, and aligned. The alignment method is not limited to the microlens array 12 and the light shield unit 13 having the wavelength selective transmitting function of embodiments of the present invention but may be also applied to alignment of a microlens array, a light shield unit, and an imaging device made of materials usually used.

Next, the action and effect of the biometric authentication apparatus 1 will be described.

In the biometric authentication apparatus 1, first, when the living body (for example, a finger tip) 2 is placed on the detecting unit 11 and the light source 10 is driven by the light source driving unit 181, light L emitted from the light L is emitted from the light source 10 toward the living body 2. The light emitted to the living body 2 is, for example, scattered on the inside of the living body 2 and absorbed by a vein. On the other hand, the microlenses 12C in the microlens array 12 are disposed so as to form an observation plane of the inside of the living body 2 on the light reception plane of the imaging device 14, so that the light in the living body 2 is condensed by the microlens array 12 and enters into the imaging device 14. In such a manner, the imaging device 14 obtains image data of the vein (vein pattern) of the living body 2. The vein pattern obtained by the imaging device 14 is properly subjected to an image processing in the image processing unit 15 and input to the authenticating unit 17. The authenticating unit 17 performs authentication by comparing the input vein pattern with a vein authentication pattern held in the pattern holding unit 16. A result of final biometric authentication (authentication result data Dout) is output, and the biometric authenticating process is finished.

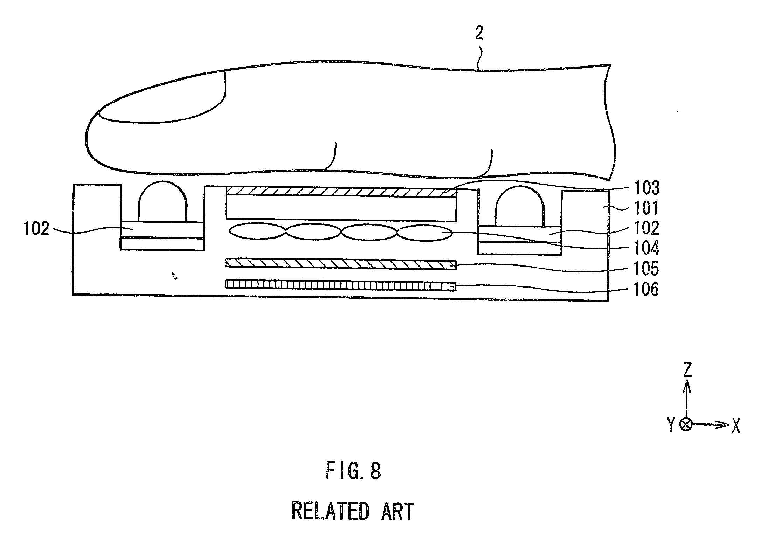

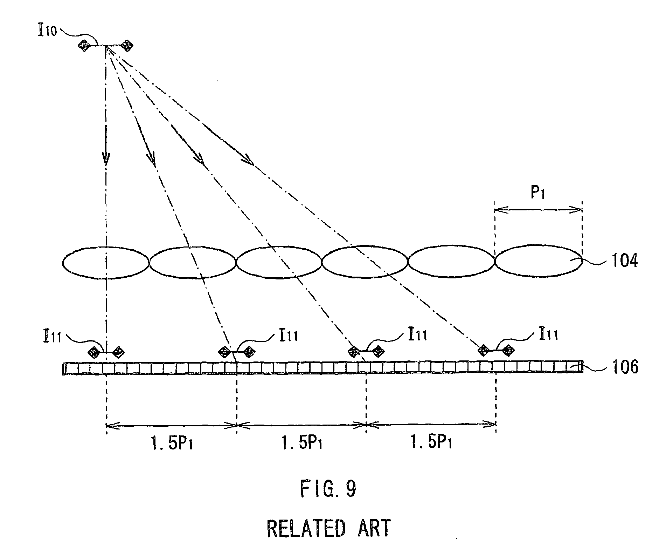

The operation of the microlens array 12 and the light shield unit 13 will now be described in comparison with the related art illustrated in FIGs. 8 and 9. FIG. 8 is a cross section taken along line Z-X illustrating a schematic configuration of a biometric authentication apparatus according to a related art. FIG. 9 is a schematic diagram for explaining the operation of the biometric authentication apparatus illustrated in FIG. 8.

As illustrated in FIG. 8, in the biometric authentication apparatus according to the related art, a microlens array 104 made by a plurality of microlenses, a near infrared light (IR) transmission filter 105, and an imaging device 106 are disposed in this order in a casing 101 below a detecting unit 103. The microlenses in the microlens array 104 are closely arranged in a matrix like in the biometric authentication apparatus 1 of the embodiment. With the configuration, unnecessary visible light in light emitted from light sources 102 toward the living body 2 and condensed by the microlens array 104 is blocked by the near infrared light transmission filter 105, and near infrared light is selectively passed. The near infrared light which is selectively passed by the near infrared light transmission filter 105 falls on the imaging device 106, and image data of high precision is generated.

In such a configuration, although the image data of high precision is obtained, the thickness of the entire apparatus is increased by providing the near infrared light transmission filter 105. Consequently, it becomes difficult to reduce the thickness of the apparatus.

On the other hand, in the embodiment, by adding an optical functional material (colorant) such as a polymer material or metal material which blocks visible light into a thermoplastic resin as the base material of the microlens array 12, the microlens array 12 is also provided with the function of the near infrared light transmission filter 105. Without providing the near infrared light transmission filter as in the apparatus according to the related art, near infrared light is selectively passed to the imaging device 14.

In the biometric authentication apparatus according to the related art, as illustrated in FIG. 9, rays of light from an image I₁₀ of the living body 2 enters into the plurality of microlenses, and a plurality of images I₁₁ are formed on the imaging device 106. For example, in the case where the diameter (pitch) of the microlens is set to P₁ and the image forming magnification is set to 2:1, a plurality of images I₁₁ each having a size which is the half of the image I₁₀ are formed at an interval which is 1.5 times as large as the diameter of the microlens on the imaging device 106. As a result, crosstalk occurs between the microlenses, and the picture quality deteriorates.

On the other hand, in the embodiment, the light shield unit 13 having openings in the regions between the microlenses 12C is provided on the light outgoing side of the microlens array 12 (the imaging device side). The light shield unit 13 has a lattice shape corresponding to the placement of microlenses on the X-Y plane and has a length (height) H in the Z direction. With the configuration, occurrence of crosstalk is suppressed on the imaging device 14.

Further, by adding an optical functional material such as a polymer material or metal material into a thermoplastic resin as the base material of the light shield unit 13, the light shield unit 13 is provided with the function of blocking visible rays in addition to near infrared light. With the function, occurrence of crosstalk of near infrared light from the neighboring microlens array 12 is suppressed, so that authentication precision of the biometric authentication apparatus 1 may be further increased.

In the peripheral regions 12B, 13B, and 14B of the microlens array 12, the light shield unit 13, and the imaging device 14, the openings 12a to 12d, the projections 13a to 13d, the through holes 12e to 12h (or the microlenses 12i to 12l) and 13e to 13h, and the alignment marks 14a to 14d for alignment are provided, respectively. With the configuration, adjustment of alignment at the time of assembly is unnecessary.

As described above, in the biometric authentication apparatus 1 of the embodiment, the microlens array 12 for condensing light from the living body 2 selectively transmits light in the wavelength band for authentication (near infrared light). Consequently, the image data of the living body 2 is obtained on the basis of the light in the wavelength band for authentication. That is, since the microlens array 12 has the light condensing function and the wavelength selective-transmission function, light in the wavelength band (for example, visible light) which is unnecessary for authentication is eliminated, and image data based on light in the wavelength band (near infrared light) necessary for authentication is obtained. It is therefore unnecessary to separately provide a wavelength selective-transmission filter in the apparatus unlike the related art. Thus, while maintaining high authentication precision, the thinner biometric authentication apparatus 1 may be realized.

Since the light shield unit 13 having the openings in the regions between the microlenses 12C is provided on the light outgoing side (the image device side) of the microlens array 12, occurrence of crosstalk as described above is suppressed over the imaging device 14. Further, the light shield unit 13 is manufactured by adding, to a thermoplastic resin material that blocks visible light and near infrared light, an optical functional material such as a polymer material or metal material which blocks the same wavelength range of the light. Consequently, occurrence of crosstalk in not only the visible light but also in the near infrared light is suppressed. Therefore, a living body is authenticated on the basis of an image of high picture quality which is hardly influenced by crosstalk, and the living body authentication precision improves.

Since light in the wide wavelength range is blocked, crosstalk is suppressed and noise light such as ghost and flare is suppressed. Further, to suppress ghost, flare, and the like, desirably, the light shield unit 13 blocks light and, simultaneously, has high absorption rate.

Further, since the openings and the like for alignment are provided in the peripheral regions 12B, 13B, and 14B of the microlens array 12, the light shield unit 13, and the imaging device 14, adjustment of alignment at the time of assembly becomes unnecessary, and the assembly alignment becomes easier. Thus, manufacturing cost is suppressed.

Although the present invention has been described above by the embodiment, the invention is not limited to the embodiment but may be variously modified. For example, although the case of providing the circular or rectangular openings in the peripheral regions 12B, 13B, and 14B in the microlens array 12, the light shield unit 13, and the imaging device 14 for alignment has been described above, the shape of the opening is not limited to those shapes, but may be other shapes. Although the openings (holes) are formed in the microlens array 12 and the projections to be fit in the openings are provided for the light shield unit 13 in the foregoing embodiment, they may be provided in an opposite manner. Specifically, the openings (holes) may be provided for the light shield unit 13, and the projections to be fit in the openings may be provided for the microlens array 12.

Although the configuration in which the light sources 10 are provided at both ends in the longitudinal direction of the living body 2 has been described as an example in the foregoing embodiment, the positions of the light sources 10 are not limited to the example. Specifically, in the configuration in which the light source 10 is disposed on the same side of the imaging device 14 with respect to the detecting unit 11, the light source 10 may be disposed only one side.

The present invention is not limited to the components in the foregoing embodiment. In addition, a transmittance distribution filter for reducing light amount unevenness, for example, in the case of obtaining a vein pattern, a near infrared light transmission filter, and the like may be disposed. The near infrared light transmission filter is a filter that selectively transmits light in the wavelength range of near infrared light and is made of, for example, adding copper phthalocyanine compound, metal-free phthalocyanine compound, anthraquinone dye, or the like to an acrylic resin. By disposing such a near infrared transmission filter, outside light and the like is removed, and an image of higher quality is obtained more easily.

In the foregoing embodiment, the case of properly performing the image process on the image data obtained by the imaging device 14 in the image processing unit 15 and, then, performing authentication has been described. However, the invention is not limited to the case. For example, the authenticating unit 17 may directly perform authentication on the basis of image data from the imaging device 14 without providing the image processing unit 15. In such a case, the apparatus configuration is further simplified, and the entire apparatus becomes thinner.

Although the case of performing the biometric authentication on the basis of a structure in the living body 2, for example, a vein pattern has been described in the foregoing embodiment, the invention is not limited to the case. For example, it is also possible to obtain a fingerprint pattern on the surface of the living body 2 (fingertip) and, on the basis of the result, output a final authentication result.

Although the vein authentication has been described as an example in the foregoing embodiment, the invention is not limited to it. The invention may be also used for, for example, fingerprint authentication. In this case, a white light source may be used as the light source.

In the foregoing embodiment, the case where the microlens array 12 selectively transmits near infrared light has been described as an example. The wavelength range of selectively transmitting light is not limited to the near infrared range. Specifically, for example, in the case of obtaining the fingerprint pattern of the surface of the living body 2 (fingertip) and performing biometric authentication on the basis of the result, another wavelength range, for example, a visible range or a near-ultraviolet range may be used.

The present application contains subject matter related to that disclosed in Japanese Priority Patent Application JP 2009-168095 filed in the Japan Patent Office on July 16, 2009.

It should be understood by those skilled in the art that various modifications, combinations, sub-combinations and alterations may occur depending on design requirements and other factors insofar as they are within the scope of the appended claims.

## Claims

1. A biometric authentication apparatus (1) comprising:
a light source (10) for emitting light in a wavelength range including a wavelength range for authentication toward a living body;
a microlens array (12) for condensing light from the living body and selectively, transmitting light in the wavelength range for authentication;
an imaging device (14) for obtaining image data of the living body on the basis of the light condensed by the microlens array; and
an authentication unit (17) for authenticating the living body on the basis of the image data obtained by the imaging device;
wherein the microlens array (12) is formed of a base material comprising:
a resin made of a thermoplastic resin; and
a light shield material contained in the resin and blocking light in a wavelength range different from the wavelength range for authentication.

2. The biometric authentication apparatus according to claim 1, wherein the wavelength range for authentication is a near infrared range.

3. The biometric authentication apparatus according to claim 1, further comprising, on a light outgoing side of the microlens array, a light shield unit (13) having openings corresponding to a plurality of microlenses and blocking light in a wavelength range including the wavelength range for authentication.

4. The biometric authentication apparatus according to claim 3, wherein the light shield unit is provided integrally with the microlens array.

5. The biometric authentication apparatus according to claim 4, wherein each of the microlens array and the light shield unit is provided with one or a plurality of aligning mechanisms.

6. The biometric authentication apparatus according to claim 5, further comprising, as the aligning mechanisms,
a hole provided for either the microlens array or the light shield unit, and
a projection provided for the other member and to be fit in the hole.

7. The biometric authentication apparatus according to claim 3, wherein the light shield unit (13) comprises:
a resin layer made of a thermoplastic resin; and
an optical functional material for blocking visible light contained in the resin layer.

## Patentansprüche

1. Vorrichtung zur biometrischen Authentifizierung (1), umfassend:
eine Lichtquelle (10) zum Emittieren von Licht in einem Wellenlängenbereich, der einen Wellenlängenbereich zur Authentifizierung umfasst, in Richtung eines lebenden Körpers;
Mikrolinsenanordnung (12) zum Sammeln von Licht von dem lebenden Körper und zum ausgewählten Übertragen von Licht in dem Wellenlängenbereich zur Authentifizierung;
Abbildungseinrichtung (14) zum Erhalten von Bilddaten des lebenden Körpers auf Basis des durch die Mikrolinsenanordnung gesammelten Lichts; und
Authentifizierungseinheit (17) zum Authentifizieren des lebenden Körpers auf Basis der Bilddaten, die durch die Abbildungseinrichtung erlangt wurden;
wobei die Mikrolinsenanordnung (12) aus einem Basismaterial gebildet wird, das aufweist:
ein Harz, das aus einem thermoplastischen Harz gemacht ist; und
ein Licht-Abschirm-Material, das in dem Harz enthalten ist und das Licht in einem Wellenlängenbereich blockt, der von dem Wellenlängenbereich zur Authentifizierung verschieden ist.

2. Vorrichtung zur biometrischen Authentifizierung nach Anspruch 1,
wobei der Wellenlängenbereich zur Authentifizierung ein Nahinfrarotbereich ist.

3. Vorrichtung zur biometrischen Authentifizierung nach Anspruch 1, weiterhin aufweisend, auf einer Lichtausgangsseite der Mikrolinsenanordnung, eine Licht-Abschirm-Einheit (13), die Öffnungen hat, welche einer Mehrzahl von Mikrolinsen entsprechen und die in einem Wellenlängenbereich, der den Wellenlängenbereich zur Authentifizierung enthält, Licht blockt.

4. Vorrichtung zur biometrischen Authentifizierung nach Anspruch 3,
wobei die Licht-Abschirm-Einheit in die Mikrolinsenanordnung integriert vorgesehen ist.

5. Vorrichtung zur biometrischen Authentifizierung nach Anspruch 4,
wobei sowohl die Mikrolinsenanordnung als auch die Licht-Abschirm-Einheit mit einem oder mehreren Ausricht-Mechanismen versehen ist.

6. Vorrichtung zur biometrischen Authentifizierung nach Anspruch 5, weiterhin aufweisend, als Ausricht-Mechanismus, ein Loch, das entweder in der Mikrolinsenanordnung oder der Licht-Abschirm-Einheit vorgesehen ist, und
einen Vorsprung, der an dem anderen Element vorgesehen ist und in das Loch passen soll.

7. Vorrichtung zur biometrischen Authentifizierung nach Anspruch 3,
wobei die Licht-Abschirm-Einheit (13) aufweist:
eine Harzschicht, die aus thermoplastischem Harz gemacht ist; und
ein optisches Funktionsmaterial zum Blocken von sichtbarem Licht, das in der Harzschicht enthalten ist.

## Revendications

1. Appareil d'authentification biométrique (1) comportant :
une source lumineuse (10) pour émettre une lumière dans une plage de longueur d'onde comprenant une plage de longueur d'onde pour l'authentification d'un être vivant ;
un réseau de micro lentilles (12) pour condenser la lumière provenant de l'être vivant et transmettre sélectivement la lumière dans une plage de longueur d'onde pour l'authentification ;
un dispositif d'imagerie (14) pour obtenir des données d'image de l'être vivant en fonction de la lumière condensée par le réseau de micro lentilles ; et
une unité d'authentification (17) pour authentifier l'être vivant en fonction des données d'image obtenues par le dispositif d'imagerie ;
dans lequel le réseau de micro lentilles (12) est formé d'un matériau de base comportant :
une résine réalisée en une résine thermoplastique; et
un matériau d'écran de protection contre la lumière contenue dans la résine et bloquant la lumière dans une plage de longueur d'onde différente de la plage de longueur d'onde pour l'authentification.

2. Appareil d'authentification biométrique selon la revendication 1, dans lequel la plage de longueur d'onde pour l'authentification est une plage se trouvant dans le proche infrarouge.

3. Appareil d'authentification biométrique selon la revendication 1, comportant en outre, sur le côté de sortie de lumière du réseau de micro lentilles, une unité d'écran de protection contre la lumière (13) possédant des ouvertures correspondant à une pluralité de micro lentilles et bloquant la lumière dans une plage de longueur d'onde comprenant la plage longueur d'onde pour l'authentification.

4. Appareil d'authentification biométrique selon la revendication 3, dans lequel l'unité d'écran de protection contre la lumière est prévue de façon solidaire avec le réseau de micro lentilles.

5. Appareil d'authentification biométrique selon la revendication 4, dans lequel chacun du réseau de micro lentilles et de l'unité d'écran de protection contre la lumière est muni d'un ou d'une pluralité de mécanismes d'alignement.

6. Appareil d'authentification biométrique selon la revendication 5, comportant en outre, en tant que mécanismes d'alignement,
un trou prévu pour soit le réseau de micro lentilles soit l'unité d'écran de protection contre la lumière, et
une partie saillante prévue pour l'autre élément et pour être fixée dans le trou.

7. Appareil d'authentification biométrique selon la revendication 3, dans lequel l'unité d'écran de protection contre la lumière (13) comporté :
une couche de résine réalisée en une résine thermoplastique ; et
un matériau fonctionnel optique pour bloquer la lumière visible contenue dans la couche de résine.
